# EUROPÄISCHE PATENTANMELDUNG

(11) **EP 2 111 088 A2**
(43) Veröffentlichungstag der Anmeldung: **21.10.2009**
(21) Anmeldenummer: 09154870.1
(22) Anmeldetag: 11.03.2009
(51) Int. Cl.: H05K 7/14

(54) **Modulare Montagebasis für elektrische Geräte**

(30) Priorität: 17.04.2008 DE 202008005245 U; 20.10.2008 DE 202008013992 U
(71) Anmelder: Weidmüller Interface GmbH & Co. KG, 32758 Detmold (DE)
(72) Erfinder: Vianden, Peter, 32689 Kalletal (DE)
(74) Vertreter: Dantz, Jan Henning

(57) **Zusammenfassung**

Modulare Montagebasis (1), die miteinander koppelbare Backplanemodule (3), aufweist, wobei die Backplanemodule (3) Busleiter (4) aufweisen, die miteinander leitend gekoppelt sind, wobei zumindest die Backplanemodule (3) vorzugsweise jeweils eine Leiterplatte (6) aufweisen, die Leiterbahnen, insbesondere Stromschienen (7, 8, 9) aufweist, die von Backplanemodul (3) zu Backplanemodul (3) mittels Verbindern (10 - 12) leitend miteinander verbunden sind.

## Beschreibung

Die Erfindung betrifft eine modulare Montagebasis für elektrische Geräte nach dem Oberbegriff des Anspruchs 1.

Es ist bekannt, aus zusammenfügbaren Modulträgern, die mit miteinander koppelbaren Busabschnitten versehen sind, eine Montagebasis für elektrische Geräte zu bilden, welche vorzugsweise direkt auf einer Unterlage wie einer Montagewand montierbar ist.

Beispiele eines derartigen Standes der Technik zeigen die US 6,881,101B2 und die EP 1 771 054 A1.

Es sind ferner Ausgestaltungen bekannt, bei denen aus koppelbaren Busabschnitten Busanordnungen in Tragschienen realisiert werden (DE 10 2006 031 129 A1).

Darüber hinaus ist es bekannt, aus reihenklemmenartigen, auf Tragschienen montierbaren Modulen mit koppelbaren Busabschnitten eine modulare Montagebasis zu realisieren, auf welche Elektronikgehäuse aufsetzbar sind, wobei an die Module Feldgeräte verschiedenster Art anschließbar sind. Ein Gateway dient zur Verbindung mit einem übergeordneten Bussystem.

Es ist zudem bekannt, aus in einem Gehäuse angeordneten, koppelbaren Leiterplattenabschnitten eine Montagebasis aufzubauen (siehe die gattungsgemäße DE 36 16 662 A1).

Ausgehend von diesem Stand der Technik ist es die Aufgabe der Erfindung, eine besonders einfach aufgebaute Montagebasis zu realisieren, die sich sowohl gut für Leistungsapplikationen, also zur Übertragung auch höherer elektrischer Leistungen als vorzugsweise auch zur Übertragung von Daten und Signalen eignet.

Die Schaffung einer derartigen Montagebasis ist die Aufgabe der Erfindung.

Die Erfindung löst diese Aufgabe durch den Gegenstand des Anspruchs 1.

Diese Modularisierung führt insbesondere bei Leistungsapplikationen zu einer Verringerung des Installations- und Wartungsaufwandes. Insbesondere der Einsatz von Standardkomponenten verbessert zudem die Skalierbarkeit. Die Lagerhaltung wird vereinfacht.

Neben applikativen Vorteilen, zu denen eine modulare, nicht sichtbare Stromverteilung sowie eine vorzugsweise werkzeuglose, intuitive Installation und Wartung gehören, ist die hohe Stromtragfähigkeit im industriellen Temperaturbereich hervorzuheben.

Die direkte Verbindung der als massive Stromschiene ausgeführten Leiterbahnen ist dabei besonders vorteilhaft hinsichtlich einer hohen Stromtragfähigkeit, die für die Energieverteilung insbesondere auch bei Geräten mit Leistungselektronik eine Schlüsselanforderung darstellt. Die Substitution der gemäß dem Stand der Technik gebräuchlichen zusätzlichen Hilfskomponenten, wie z.B. Anschlussbolzen mit Strombrücken oder Leiterplatten-Steckverbinder, reduziert sowohl elektrische und thermische Übergangswiderstände erheblich. Zudem werden die Kosten bei der Verarbeitung sowie der erforderliche Bauraum verringert und schließlich die Zuverlässigkeit und Sicherheit der Verbindung erhöht.

Denkbar sind beispielsweise Auslegungen für 200 A bis 1000V.

Eine optionale Entwärmung optimiert das Temperaturverhalten weiter.

Wenn die mechanische Fixierung des aufgesteckten Gerätes gleichzeitig mit der elektrischen Kontaktierung, vorzugsweise werkzeuglos, erfolgt, ergibt sich eine Reduzierung der Arbeitsschritte, die besonders vorteilhaft bei der Installation und im Servicefall ist.

Die Anschlussstelle zur nächsten Backplane ist vorzugsweise fingersicher ausgeführt und steht nicht über das Gerät hinaus.

Vorteilhafte Ausgestaltungen der Erfindung sind den Unteransprüchen zu entnehmen.

Nachfolgend wird die Erfindung anhand von Ausführungsbeispielen näher beschrieben. Es zeigt:
- Fig.1: eine schematische Darstellung einer aus Backplaneabschnitten - Lei- terplattenabschnitten - zusammengesetzten bzw. zusammensetzbaren Montagebasis;
- Fig. 2a-c: verschiedene Ansichten eines schematisch dargestellten Einspeisemo- duls;
- Fig. 3: eine schnittartige Ansicht durch eine Montagebasis mit darauf aufge- setzten Baugruppen;
- Fig. 4: eine schnittartige Ansicht durch eine auf eine Montageplatte montierte Montagebasis und das Koppeln eines Backplaneabschnitts mit dieser Montagebasis;
- Fig. 5a, b: einen Schnitt durch miteinander in zwei Verbindungsarten gekoppelte B ackplaneab schnitte;
- Fig. 6: einen Schnitt durch miteinander in einer weiteren Verbindungsart ge- koppelte Backplaneabschnitte;
- Fig. 7: eine Draufsicht auf eine Montagebasis; und

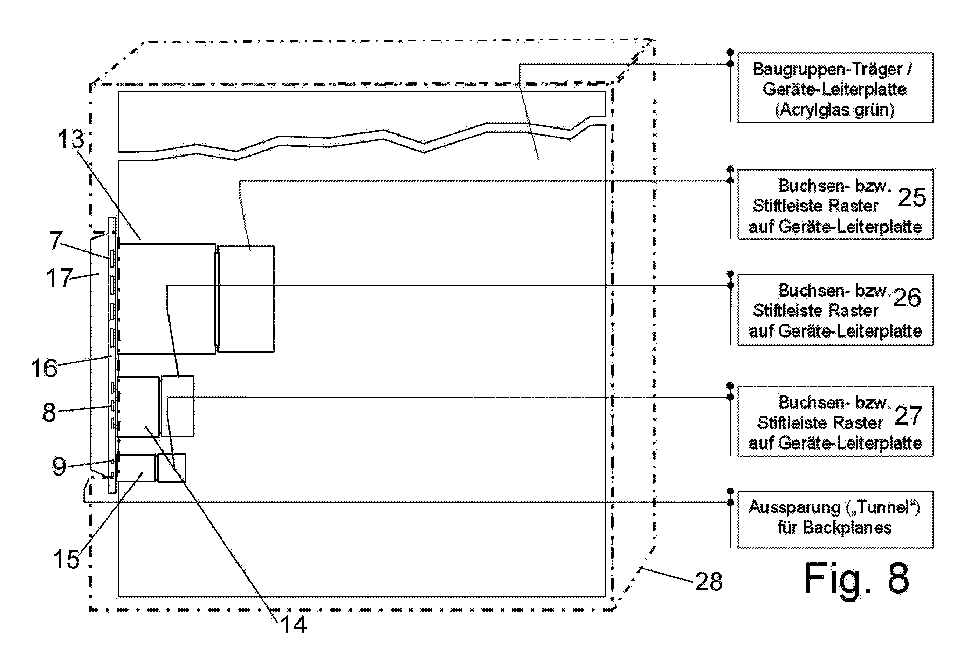

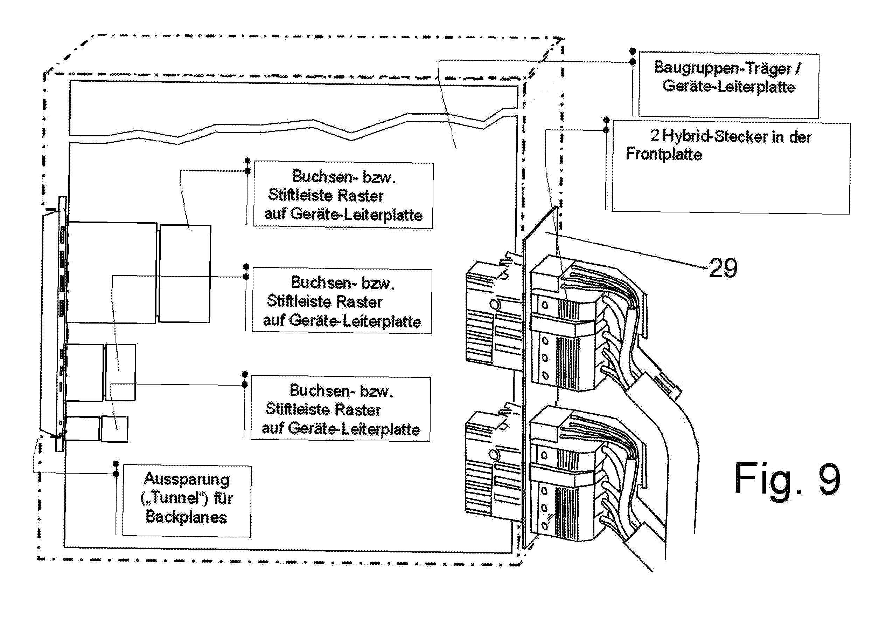

- Fig. 8 bis 9: weitere Ansichten einer Montagebasis;
- Fig. 10: eine beispielhafte Darstellung einer auf einer Montagebasis aufbau- enden Installation.

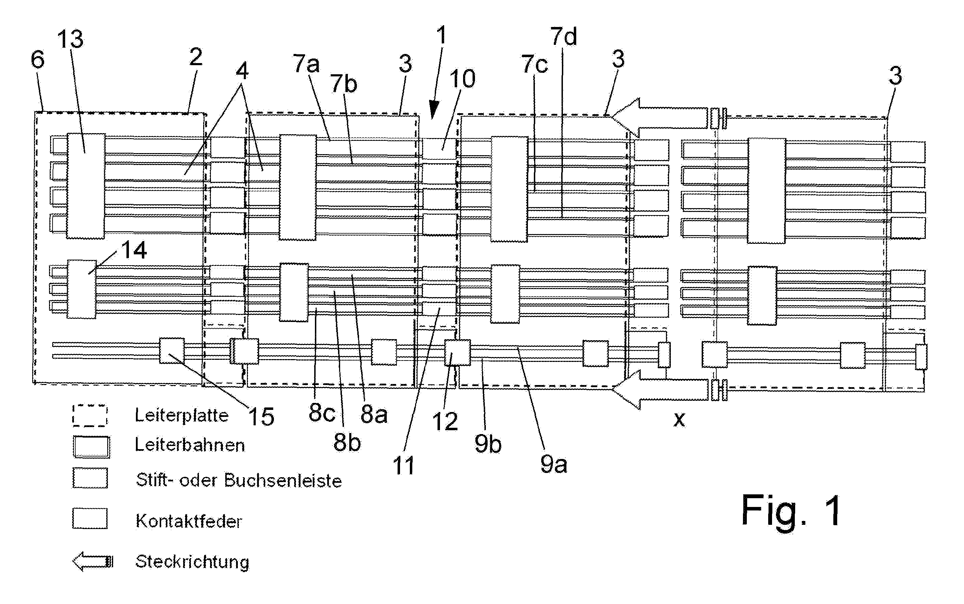

Fig. 1 zeigt eine Draufsicht auf eine modulare Montagebasis 1, die miteinander koppelbare Backplanemodule 2, 3 aufweist, von denen eines als Einspeisemodul 2 zur Realisierung einer zentralen Stromversorgung ausgelegt ist.

An das Einspeisemodul 2 ist eines der Backplanemodule 3 angeschlossen, an das sich wiederum weitere zu einer Reihenanordnung miteinander gekoppelte Backplanemodule 3 anschließen.

Sowohl das Einspeisemodul 2 als auch die Backplanemodule 3 weisen Busleiter 4 auf, die in Anreihrichtung miteinander leitend gekoppelt sind, was weiter unten noch näher erläutert wird. An das Einspeisemodul 2 werden dabei hier nur zu einer Richtung hin weitere Backplanemodule 3 angekoppelt.

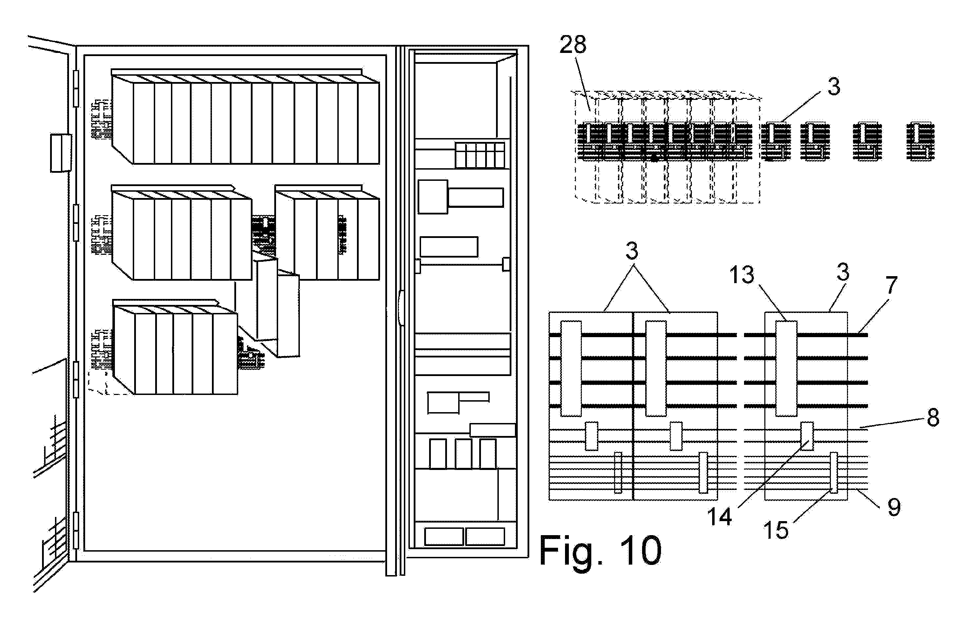

Auf die Backplanemodule 3 sind ferner vorzugsweise Elektronikgehäuse (siehe auch Fig. 10) aufsetzbar, um an jedes Modul vorzugsweise einen Verbaucher anschließen zu können.

Das Einspeisemodul 2 und die Backplanemodule 3 bauen jeweils vorzugsweise auf wenigstens einer Leiterplatte 6 auf, auf der Leiterbahnen angeordnet oder in die Leiterbahnen, vorzugsweise Stromschienen 7, 8, 9, eingelassen sind. Vorzugsweise sind Stromschienen 7, 8, 9 verschiedenen Querschnitts vorgesehen, von denen sich Stromschienen 7a, 7b, 7c, 7d eines ersten größeren Querschnitts zur Übertragung auch höherer elektrischer Leitungen ausgelegt sind (z.B. 800 V 41A), die Stromschienen 8a, 8b, 8c hier eines mittleren Querschnitts zur Übertragung einer Hilfsenergie (z.B. 24 V, 17,5 A) und die Stromschienen 9a, 9b des hier kleinsten Querschnitts zur Übertragung von Daten (z.B. 5V, 10mA).

Vorzugsweise werden die Stromschienen 7 - 9 benachbarter Backplaneabschnitte 2, 3 mittels werkzeugfrei betätigbaren Verbindern 10, 11, 12 miteinander gekoppelt.

Auf der Leiterplatte 6 können ferner jeweils einer oder mehrere Anschlussvorrichtungen, insbesondere Stift- und/oder Buchsenleisten 13, 14, 15 angeordnet sein, die entsprechend der jeweils zu übertragenden Energie oder Signale dazu ausgelegt sind, die Elektronikgehäuse bzw. eine in dem Elektronikgehäuse angeordnete Elektronik und/oder sonstige Verbraucher an die Busleiter anzuschließen.

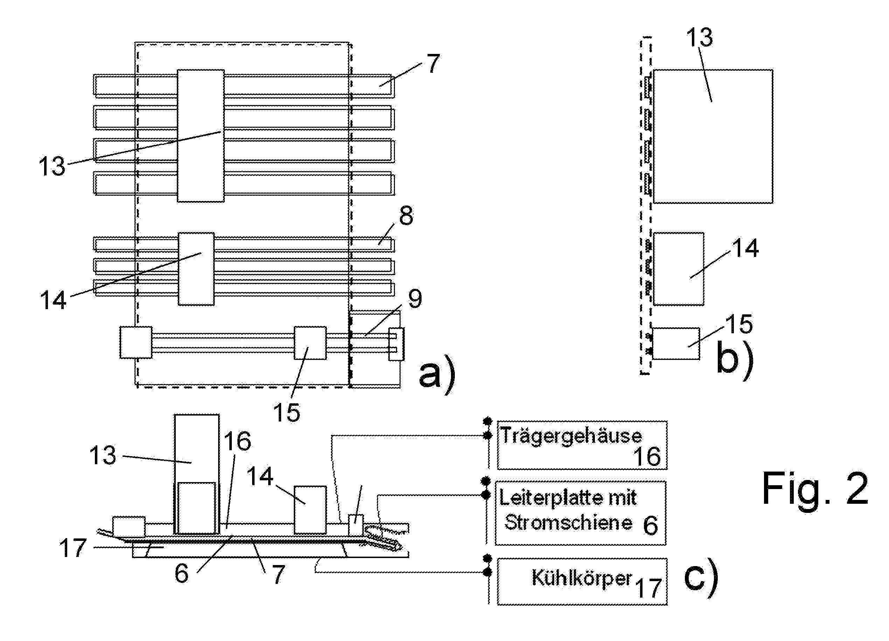

Wie in Fig. 2 zu erkennen, können die Leiterplatten 6 mit den Stromschienen 7, 8, 9 in einem sie umgebenden Trägergehäuse 16 oder einem sie umgebenden Trägermaterial aufgenommen sein.

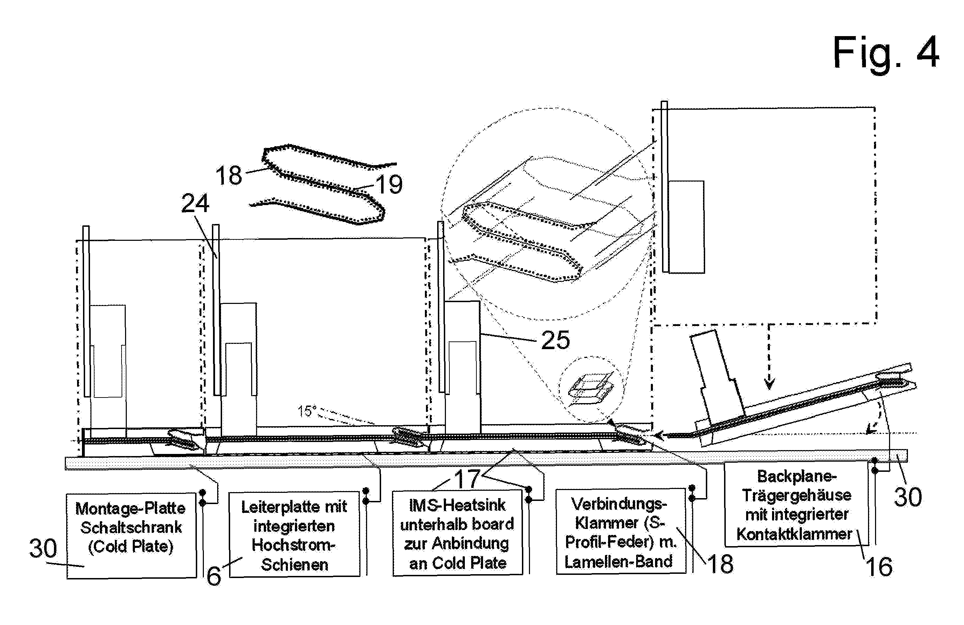

An der Leiterplatte 6 kann ferner ein Kühlkörper 17 angeordnet sein. Vorzugsweise wird der Kühlkörper 17 an einer der Hauptaußenflächen der Leiterplatte 6, insbesondere auf der von den Anschlussvorrichtungen abgewandten Seite der Leiterplatte 6, ausgebildet/angeordnet, um entstehende Wärme möglichst direkt in eine Unterlage, insbesondere eine Montageplatte 30 (Fig. 4) oder dgl. abzuleiten, auf welcher die Montagebasis vorzugsweise montiert wird.

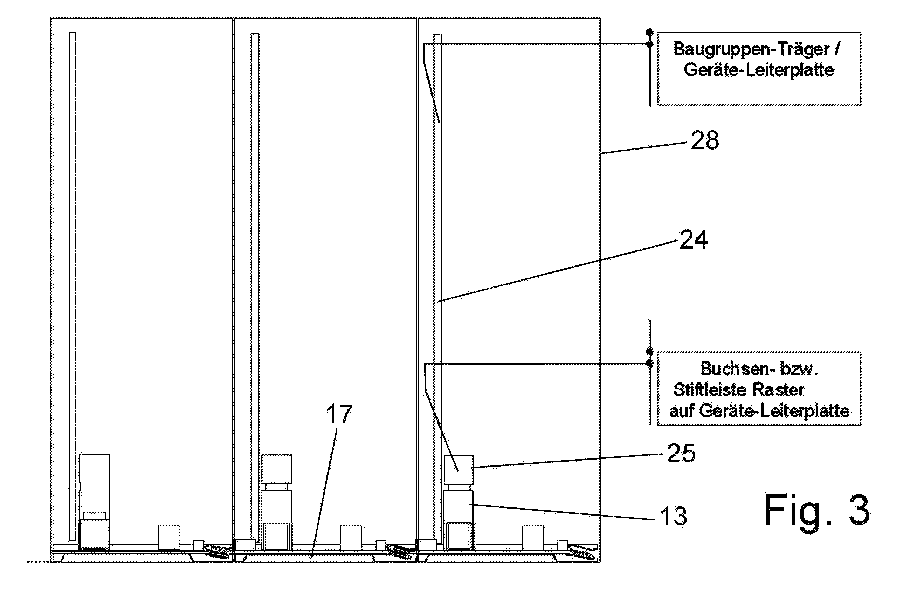

Als Verbinder 10, 11 insbesondere der (Hoch-)Stromschienen) 7 sind nach einer Variante (Fig. 4) Kontaktfedern, insbesondere Kontaktfederklammern vorgesehen, insbesondere S-förmige Kontaktfederklammern 18, welche zum Aufsetzen auf freie Enden der Stromschienen 7, 8 ausgelegt sind (siehe Fig. 4), welche seitlich über den Rand der Leiterplatte 6 in Anreihrichtung X (Fig. 1 vorstehen) und etwas schräg zur Ebene der Leiterplatte 6 gebogen sein können (Fig. 3).

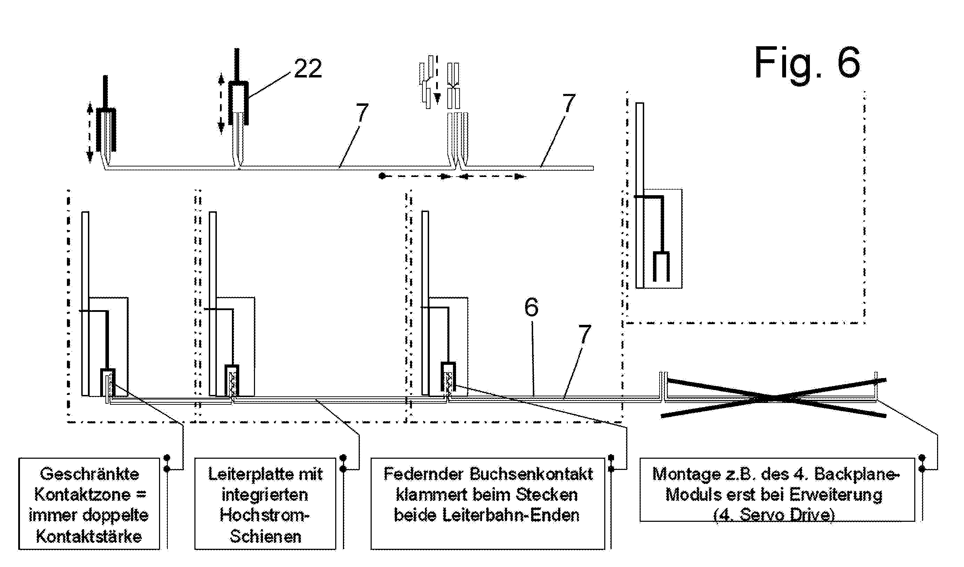

Die Kontaktklammern 18 können aus einem Federblech gefertigt sein, das beidseitig mit einem Kontaktlamellenband 19 belegt ist (Fig. 6).

Derart werden insbesondere die Stromschienen 7, 8 zur Übertragung einer höheren Leistung vorzugsweise werkzeugfrei miteinander verbunden.

Es ist denkbar, die Stromschienen 9 zur Daten- und/oder Signalübertragung mittels korrespondierenden Stift- und Buchsenleisten 12 miteinander zu verbinden. Dazu kann die Leiterplatte 6 im Bereich der Stromschienen 9 in Anreihrichtung etwas breiter ausgelegt sein als in dem Bereich, in welchem sie die Stromschienen 7, 8 trägt, um auf ihr die Stift- und Buchsenleisten 12 anordnen zu können.

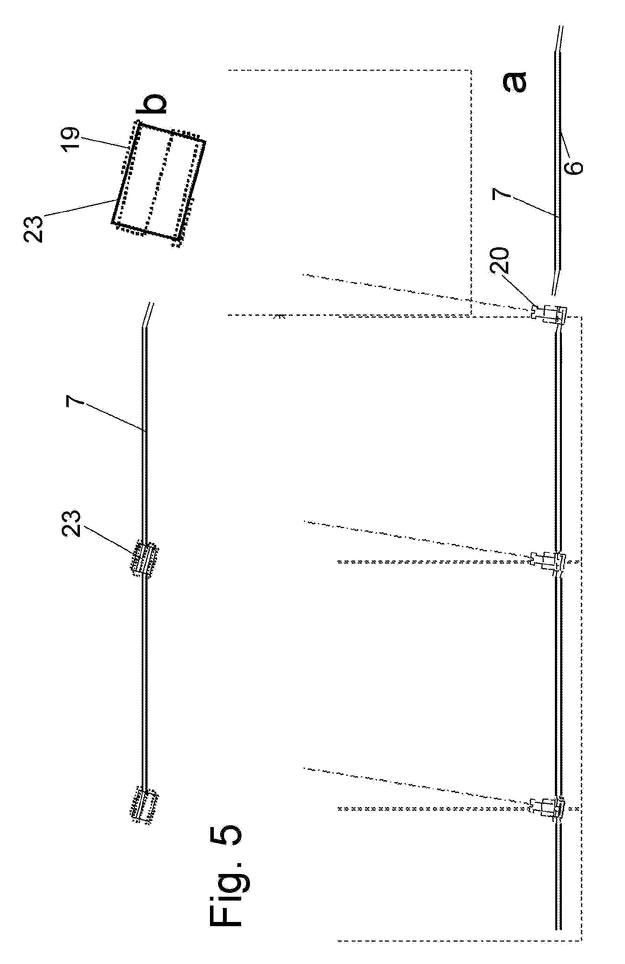

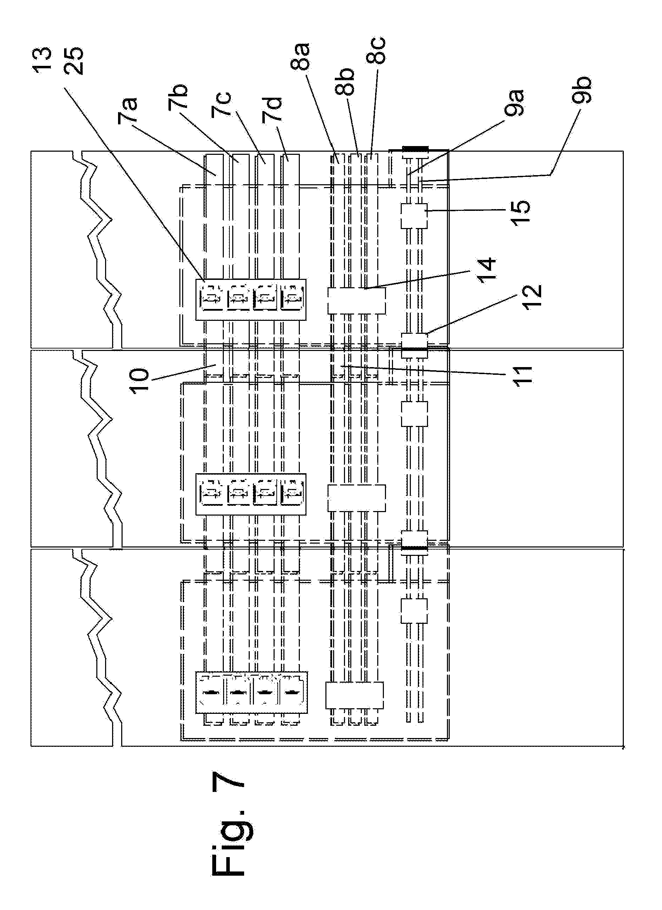

Es ist auch denkbar, als die Verbinder 10, 11 Schraubanschlussvorrichtungen, insbesondere Zugbügelanschlüsse 20, zu verwenden (siehe Fig. 5b) oder Hülsen 23, die mit einem Kontaktmaterial, insbesondere einem Kontaktband, belegt sind. (Fig. 5b). Die Verbinder 10, 11 verbinden dabei jeweils die über die Leiterplattenränder in Anreihrichtung überstehenden Abschnitte der Stromschienen 7, 8 leitend miteinander (Fig. 4 - 7).

Fig. 6 zeigt als Verbinder 10, 11 eine Art Direktsteckanschluss, bei dem miteinander verschränkte Enden der Stromschienen, welche seitlich über den Leiterplattenrand vorstehen mittels federndem buchsenartigen Kontakt 22 miteinander verbunden sind, der diese Stromschienenabschnitte direkt steckend miteinander verbindet.

Vorzugsweise wird auf jede Leiterplatte 6 der Backplane bzw. Montagebasis jeweils eine Elektronik aufgesetzt (Fig. 3).

Es ist vorteilhaft, diese Elektronik auf einer Leiterplatte 24 unterzubringen, die senkrecht zur Anreihrichtung ausgerichtet ist und mittels einer oder mehrerer Anschlussvorrichtungen 25, 26, 27, insbesondere Buchsen- oder Stiftleisten auf der Leiterplatte 6 angeordnet wird, um die Leiterplatte 6 bzw. deren Steckverbinder 13 bis 15 zu kontaktieren.

Die Leiterplatte 24 kann von einem Gehäuse 28 umgeben sein, welches wiederum Anschlussvorrichtungen 29 zum Anschluss von Steckern oder Buchsen aufweisen kann, um derart externe Verbraucher zu versorgen und/oder anzusteuern und/oder zu überwachen.

### Bezugszeichen

- Montagebasis: 1
- Einspeisemodul: 2
- Backplanemodul: 3
- Busleiter: 4
- Leiterplatte: 6
- Stromschienen: 7, 8, 9
- Verbinder: 10, 11, 12
- Stift- und/oder Buchsenleisten: 13, 14, 15
- Trägergehäuse: 16
- Kühlkörper: 17
- Kontaktklammern: 18
- Kontaktlamellenband: 19
- Schraubanschlussvorrichtungen: 20
- Buchsenkontakt: 22
- Hülsen: 23
- Leiterplatte: 24
- Stift- oder Buchsenleisten: 25, 26, 27
- Gehäuse: 28
- Anschlussvorrichtungen: 29
- Montageplatte: 30
- Federklammern: 31

## Patentansprüche

1. Modulare Montagebasis (1), die miteinander koppelbare Backplanemodule (3), aufweist, wobei die Backplanemodule (3) Busleiter (4) aufweisen, die miteinander leitend gekoppelt sind, wobei zumindest die Backplanemodule (3) vorzugsweise jeweils eine Leiterplatte (6) aufweisen, die Leiterbahnen, insbesondere Stromschienen (7, 8, 9) aufweist, die von Backplanemodul (3) zu Backplanemodul (3) mittels Verbindern (10 - 12) leitend miteinander verbunden sind.

2. Montagebasis nach Anspruch 1, **dadurch gekennzeichnet, dass** die Leiterplatten (6) mehrere Stromschienen (7, 8, 9) verschiedenen Querschnitts aufweisen.

3. Montagebasis nach Anspruch 1 oder 2, **dadurch gekennzeichnet, dass** Stromschienen (7a, 7b, 7c, 7d) eines ersten größeren Querschnitts zur Leistungsübertragung, Stromschienen (8a, 8b, 8c) eines zweiten mittleren Querschnitts zur Übertragung einer Hilfsenergie und Stromschienen (9a, 9b) eines dritten kleineren Querschnitts zur Übertragung von Daten vorgesehen sind.

4. Montagebasis nach einem oder mehreren der vorstehenden Ansprüche, **dadurch gekennzeichnet, dass** zumindest ein Teil der Stromschienen (7, 8) seitlich über die Ränder der jeweiligen Leiterplatten (6) vorsteht und dass die überstehenden Ränder mittels der Verbinder (10 - 12) leitend miteinander verbunden sind.

5. Montagebasis nach einem oder mehreren der vorstehenden Ansprüche, **dadurch gekennzeichnet, dass** zumindest ein Teil der Stromschienen (7, 8) als massive Kupferschienen ausgebildet sind.

6. Montagebasis nach einem oder mehreren der vorstehenden Ansprüche, **dadurch gekennzeichnet, dass** zumindest ein Teil der Verbinder (10, 11) als Federklammern (18) ausgebildet sind.

7. Montagebasis nach einem oder mehreren der vorstehenden Ansprüche, **dadurch gekennzeichnet, dass** zumindest ein Teil der Verbinder (10, 11) als S-förmige Federklammern (18) ausgebildet sind.

8. Montagebasis nach einem oder mehreren der vorstehenden Ansprüche, **dadurch gekennzeichnet, dass** zumindest ein Teil der Verbinder (10, 11) als S-förmige Federklammern (18) ausgelegt ist, die mit einem Kontaktmaterial, insbesondere einem Kontaktband, belegt sind.

9. Montagebasis nach einem oder mehreren der vorstehenden Ansprüche, **dadurch gekennzeichnet, dass** zumindest ein Teil der Verbinder (13, 14) als mit einem Kontaktband oder eine sonstigen Kontaktmaterial belegte Hülsen (23) ausgestaltet ist und/oder dass zumindest ein Teil der Verbinder (13, 14) als Zugbügelanschlüsse ausgelegt sind und/oder dass zumindest ein Teil der Verbinder (13, 14) als Buchsenanschlüsse (22) zur Aufnahme verschränkter Enden der Stromschienen (7, 8) ausgelegt sind.

10. Montagebasis nach einem oder mehreren der vorstehenden Ansprüche, **dadurch gekennzeichnet, dass** die Leiterplatten (6) mit den Stromschienen (7, 8, 9) in einem die Leiterplatte (6) umgebenden Trägergehäuse (16) oder einem sie umgebenden Trägermaterial aufgenommen sind.

11. Montagebasis nach einem oder mehreren der vorstehenden Ansprüche, **dadurch gekennzeichnet, dass** an der Leiterplatte (6) der Backplaneabschnitte vorzugsweise jeweils ein Kühlkörper (17) angeordnet ist, welcher vorzugsweise jeweils dazu ausgelegt ist, Wärme in einer Montageunterlage, auf welcher die Montagebasis montiert ist, abzuleiten.

12. Montagebasis nach einem oder mehreren der vorstehenden Ansprüche, **dadurch gekennzeichnet, dass** auf der Leiterplatte (6) ferner eine oder mehrere Anschlussvorrichtungen, insbesondere Stift- und/oder Buchsenleisten (13, 14, 15) angeordnet sind, die entsprechend der jeweils zu übertragenden Energie oder Signale dazu ausgelegt sind, eine Elektronik und/oder sonstige Verbraucher an die Busleiter anzuschließen.

13. Montagebasis nach einem oder mehreren der vorstehenden Ansprüche, **dadurch gekennzeichnet, dass** die Elektronik (28) eine Leiterplatte (24) aufweist, die vorzugsweise senkrecht zur Anreihrichtung ausgerichtet ist und mittels einer oder mehrerer Anschlussvorrichtungen (25, 26, 27), insbesondere Buchsen- oder Stiftleisten, auf der Leiterplatte (6) angeordnet wird, um die Leiterplatte (6) bzw. deren Anschlussvorrichtungen, insbesondere deren Buchsen-oder Stiftleisten (13 - 15), zu kontaktieren.

14. Montagebasis nach einem oder mehreren der vorstehenden Ansprüche, **dadurch gekennzeichnet, dass** wenigstens eines der Backplanemodule als Einspeisemodul (2) ausgelegt ist.

15. Montagebasis nach einem oder mehreren der vorstehenden Ansprüche, **dadurch gekennzeichnet, dass** die mechanische Fixierung des aufgesteckten Gerätes gleichzeitig mit der elektrischen Kontaktierung, vorzugsweise werkzeuglos, erfolgt.
